# EUROPEAN PATENT APPLICATION

(11) **EP 2 295 489 A1**
(43) Date of publication of application: **16.03.2011**
(21) Application number: 09754847.3
(22) Date of filing: 26.05.2009
(51) Int. Cl.: C08G 73/10, B32B 15/08, B32B 15/088, C08F 299/02, C09J 179/08

(54) **LINEAR POLYIMIDE PRECURSOR, LINEAR POLYIMIDE, THERMALLY CURED PRODUCT OF THE LINEAR POLYIMIDE, AND METHOD FOR PRODUCING THE LINEAR POLYIMIDE**

(30) Priority: 28.05.2008 JP 2008139646
(71) Applicant: JFE Chemical Corporation, Tokyo 111-0051 (JP)
(72) Inventor: HASEGAWA, Masatoshi, Funabashi-shi Chiba 274-8510 (JP); KITAMURA, Naoyuki, Tokyo 111-0051 (JP)
(74) Representative: Stebbing, Timothy Charles
(86) International application number: PCT/JP2009/059938
(87) International publication number: WO 2009/145339

(57) **Abstract**

A linear polyimide is produced from mellophanic dianhydride, diamine (NH₂-A-NH₂), and a monofunctional acid anhydride and contains a repeating unit represented by the following general formula (3); 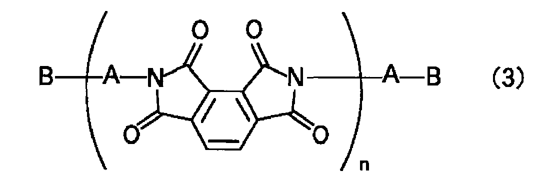 (wherein A represents a divalent aromatic diamine residue or aliphatic diamine residue, B represents a monofunctional acid anhydride residue, and n represents a degree of polymerization).

The polyimide has good solubility in organic solvents and thermoplasticity and also has high adhesive force to a copper foil and a non-thermoplastic polyimide film, a high glass transition temperature, and high toughness.

## Description

### Technical Field

The present invention relates to a linear polyimide precursor having good workability, i.e., organic solvent solubility and thermoplasticity, and also having high adhesive force to a copper film and a non-thermoplastic polyimide film, a high glass transition temperature, and high toughness, a linear polyimide and a heat-cured product thereof, and a method for producing them. Further, the present invention relates to a copper clad laminate (CCL) used as a base material of electronic circuit boards for a flexible printed circuit (FPC), a chip-on-film (COF), and tape automated bonding (TAB).

### Background Art

Polyimides have not only good heat resistance but also properties such as chemical resistance, radiation resistance, electric insulation, good mechanical properties, and the like, and are thus currently widely used for various electronic devices such as substrates for FPC, COF, and TAB, protective films of semiconductor devices, interlayer insulating films of integrated circuits, and the like. In addition to these properties, from the viewpoint of an easy production method, very high purity of films, and ease of improvement in physical properties using various available monomers, the importance of polyimides has been recently increasing.

Also, characteristics required for polyimides are increasingly made severe year by year with advances in miniaturization of electronic devices. Therefore, there has been demand for polyfunctional polyimide materials which simultaneously satisfy not only soldering heat resistance but also plural characteristics such as dimensional stability of polyimide films for heat cycles and moisture absorption, transparency, adhesion to metal substrates, moldability, micro-workability of through holes, and the like.

In recent years, demand for polyimides as base films for CCL and a heat-resistant adhesive has significantly increased. The configurations of CCL are mainly classified into the following three known types: 1) a three-layer type that is formed by bonding together a polyimide film and a copper foil with an epoxy adhesive or the like; 2) an adhesive-free two-layer type that is formed by applying polyimide varnish to a copper foil and then drying the varnish, by applying polyimide precursor (polyacrylic acid) varnish, drying the varnish, and then imidizing it, or by forming a seed layer on a polyimide film by evaporation or sputtering and then forming a copper layer by copper plating; and 3) a pseudo two-layer type that is formed by using a thermoplastic polyimide as ah adhesive layer. The two-layer CCL not using an adhesive is advantageous to application in which polyamide films are required to have a high degree of dimensional stability. However, a process for forming a polyimide film by a cast method can be applied to only one of the surfaces, and the pseudo two-layer type formed by a thermal lamination method is advantageous to the case in which copper foils are attached to both surfaces of a polyimide film (double-sided copper clad laminate).

A polyimide used for the double-sided copper clad laminate includes a non-thermoplastic polyimide film serving as a core layer which has good dimensional stability and low linear thermal expansion and thermoplastic polyimide layers formed on both surfaces of the core layer. Such a three-layer structure polyimide film is formed by applying thermoplastic polyimide varnish to both surfaces of a non-thermoplastic polyimide film, which is subjected to a discharge treatment for enhancing adhesion, and then drying the varnish. Alternatively, the film is formed by forming thermoplastic type polyimide precursor layers on both surfaces of a non-thermoplastic type polyimide precursor layer and then imidizing the precursor layers.

For the thermoplastic polyimide used in this process, in order to enhance heat melting properties, molecular design is performed to increase molecular mobility by introducing a flexible group, such as an ether bond, or an asymmetric bond, such as a meta bond, into a main chain skeleton,. However, an increase in thermoplasticity causes a significant decrease in glass transition temperature, and thus it is difficult to satisfy both the thermoplasticity and the glass transition temperature in view of molecular design.

For example, ULTEM 1000 (General Electric Co., Ltd.) is known as a commercial polyimide having both organic solvent solubility and thermoplasticity. However, soldering heat resistance is not satisfactory because of the glass transition temperature of 215°C, thereby making it impossible to apply to FPC.

The glass transition temperature of the thermoplastic polyimide layer currently used for pseudo two-layer CCL is about 250°C at most. However, the glass transition temperatures of polyimide adhesives have been recently strongly required to be further improved with lead removal of solder. There is pointed out a serious problem that at a high soldering temperature, the temperature of a thermoplastic polyimide adhesive layer is rapidly increased, and thus adhesive force is rapidly decreased also due to the influence of the water adsorbed by the adhesive layer.

As effective means for improving thermoplasticity without sacrificing the glass transition temperature, a technique using a tetracarboxylic dianhydride having an asymmetric structure is disclosed (refer to, for example, Non-patent Document 1). This technique is capable of achieving thermoplasticity while maintaining a high glass transition temperature by combining an appropriate flexible diamine and 2,3,3',4'-biphenyltetracarboxylic dianhydride (a-BPDA) having an asymmetric structure represented by formula (5) below used in place of 3,3',4,4'-biphenyltetracarboxylic dianhydride (s-BPDA) having a symmetric structure generally used and represented by formula (4) below.

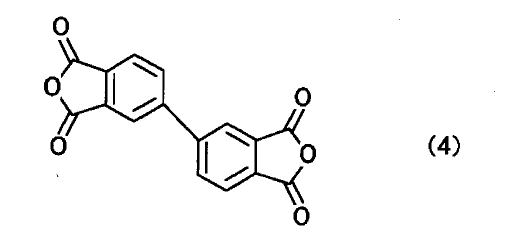

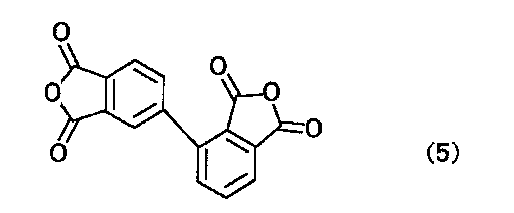

However, a polyimide produced using a-BPDA has the disadvantage that solubility in organic solvents and film toughness are not necessarily satisfactory. If a linear polyimide can be produced using an asymmetric structure-containing tetracarboxylic dianhydride alternative to a-BPDA, it is possible to provide an unconventional material satisfying all the high organic solvent solubility, high thermoplasticity, and high film toughness while maintaining a high glass transition temperature.

However, even if such a novel linear polyimide having an asymmetric structure is produced, it is a very difficult problem that a high glass transition temperature and sufficient adhesive strength (a peel strength of 1.0 kgf/cm or more as a target value) to a copper foil and a non-thermoplastic polyimide film are satisfied while maintaining the excellent workability and high film toughness. Such a material is capable of providing a heat-resistant adhesive for pseudo two-layer CCL which is very useful in the industrial field, and thus development of the material has been awaited so far. However, at present, such a material is not yet developed.
Non-patent Document 1: Macromolecules, Vol. 32, 387 (1999)

### Disclosure of Invention

### Problem to be Solved by the Invention

An object of the present invention is to provide a linear polyimide precursor having good workability, i.e., organic solvent solubility and thermoplasticity, and also having high adhesive force to a copper film and a non-thermoplastic polyimide film, a high glass transition temperature, and high toughness, or provide a linear polyimide and a heat-cured product thereof, and a method for producing them. Another object of the present invention is to provide CCL for electronic circuit boards for FPC, COF, and TAB.

### Means for Solving the Problem

As a result of repeated intensive research in consideration of the above-mentioned problem, it has been found that the above-described demand characteristics are satisfied by a terminal reactive group-containing polyimide having an asymmetric structure represented by formula (3) below, which is produced by imidizing a polyimide precursor represented by formula (1) or (2) below, and a heat-cured product thereof, leading to the achievement of the present invention.

Namely, the present invention provides a linear polyimide precursor characterized by being produced from mellophanic dianhydride, diamine (NH₂-A-NH₂), and a monofunctional acid anhydride and containing a repeating unit represented by the formula (1) or (2) below; a linear polyimide characterized by containing a repeating unit represented by the formula (3) below; and a heat-cured product characterized by being produced by a thermal crosslinking reaction of the linear polyimide. 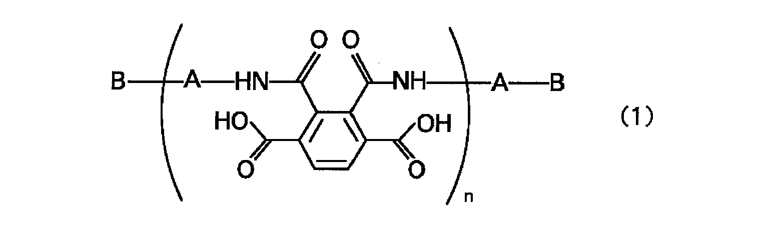 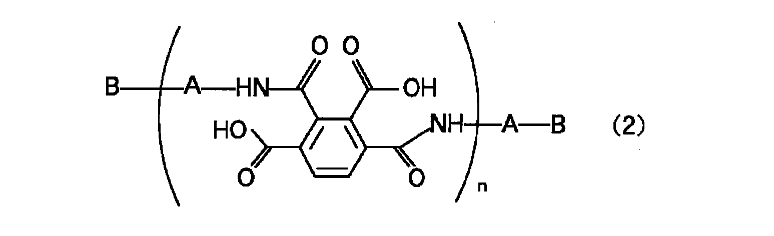 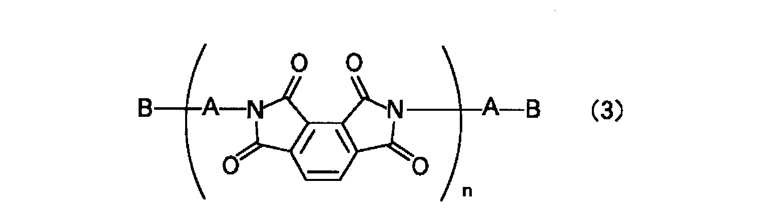 (wherein A represents a divalent aromatic diamine residue or aliphatic diamine residue, B represents a monofunctional acid anhydride residue, and n represents a degree of polymerization).

Also, the present invention provides a method for producing the polyimide of the present invention characterized by cyclodehydration (imidization) reaction of the polyimide precursor of the present invention by heating or using a dehydration reagent; and the polyimide of the present invention or the heat-cured product of the present invention which has a glass transition temperature of 270°C or more, an aprotic organic solvent solubility of 10% by mass or more, a peel strength of 1.0 kgf/cm or more when formed in a laminate with a copper foil, and a breaking elongation of 10% or more in terms of film toughness.

Further, the present invention provides a heat-resistant adhesive characterized by containing the polyimide of the present invention; and a copper clad laminate characterized by being produced by heat-laminating a non-thermoplastic polyimide film and a copper foil with the heat-resistant adhesive.

### Advantage of the Invention

According to the present invention, it is possible to provide a linear polyimide precursor having good workability, i.e., organic solvent solubility and thermoplasticity, and also having high adhesive force to a copper film and a non-thermoplastic polyimide film, a high glass transition temperature, and high toughness, or provide a linear polyimide and a heat-cured product thereof, and a method for producing them. Further, it is possible to provide CCL for electronic circuit boards for FPC, COF, and TAB.

### Best Mode for Carrying Out the Invention

Next, the present invention is described in detail by giving the best mode for carrying out the invention.

### <Molecular design>

First, a tetracarboxylic dianhydride monomer used for producing a polyimide according to the present invention is described. According to the present invention, a polyimide satisfying all the above-described demand characteristics can be produced using, instead of pyromellitic dianhydride (referred to as "PMDA" hereinafter) represented by formula (6) below, which is conventionally used as a general-purpose tetracarboxylic dianhydride component, mellophanic dianhydride (referred to as "MPDA" hereinafter) represented by formula (7) below, which is an isomer of PMDA, and a monofunctional thermal crosslinking agent, e.g., a dicarboxylic anhydride represented by formula (8) below. (6) 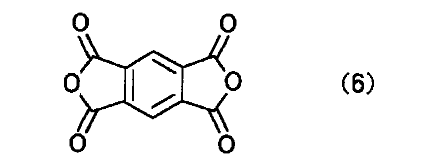 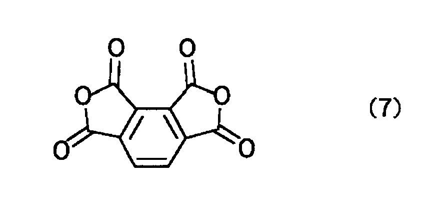 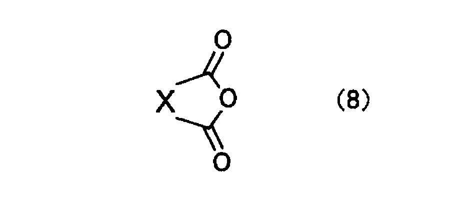 (in formula (8), X represents a reactive group of a dicarboxylic anhydride).

Examples of a reactive dicarboxylic anhydride which can be used as the thermal crosslinking dicarboxylic anhydride represented by the formula (8) include, but are not limited to, nadic anhydride, maleic anhydride, citraconic anhydride, 4-phenylethynylphthalic anhydride, 4-ethynylphthalic anhydride, 4-vinylphthalic anhydride, and the like. Among these, nadic anhydride is preferably used from the viewpoint of thermal crosslinking reactivity, physical properties of a cured product, and cost.

A conventional polyimide produced using PMDA has a linear structure at a diimide site, while a polyimide produced using MPDA has a three-dimensional bent structure introduced in its main chain. This prevents stacking between polymer chains, permits molecular motion at a temperature higher than the glass transition temperature, and exhibits high thermoplasticity. On the other hand, it is believed that since local internal rotation at a MPDA site is suppressed due to an asymmetric structure, a high glass transition temperature is maintained.

Such a bent structure in a main chain can also be introduced by using methaphenylenediamine represented by formula (9) as a diamine component. However, the use of methaphenylenediamine little contributes to improvement in solubility of the resultant polyimide in an organic solvent and often causes an unfavorable result such as a significant decrease in glass transition temperature.

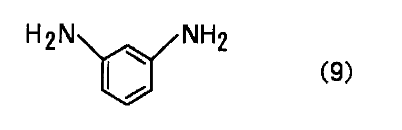

As a diamine component to be combined with MPDA, a diamine having an ether bond is effective for simultaneously achieving high solvent solubility, high thermoplasticity, and high film toughness. However, when 4,4'-oxydianiline (hereinafter referred to as "4,4'-ODA") that is a general-purpose ether group-containing diamine is used, the resultant polyimide may have unsatisfactory solubility. Therefore, high toughness can be achieved without sacrificing its solvent solubility by using a diamine represented by formula (10) below that has a structural unit of a main chain of polycarbonate, which is a representative highly tough resin.

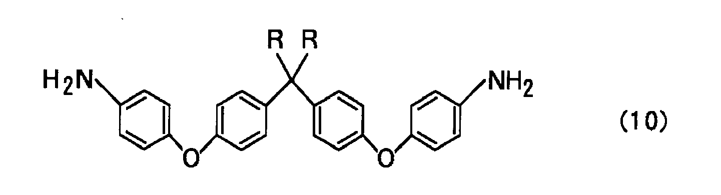

In formula (10), R represents a methyl group or a trifluoromethyl group. From the viewpoint of adhesion to a copper foil and production cost, a diamine represented by formula (11) below, i.e., 2,2-bis(4-(4-aminophenoxy)phenyl)propane (hereinafter referred to as "BAPP") is preferably used alone or used as a copolymerization component.

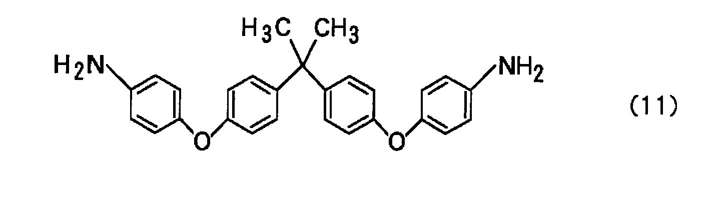

### <Control of formation of cyclic oligomer during preparation of polyimide precursor>

A method for producing a polyimide precursor and a polyimide according to the present invention is described. When a polyimide precursor or a polyimide is prepared by combining MPDA and a diamine, a cyclic oligomer exemplified by formula (12) below tends to be produced due to the binding position of an acid anhydride group that is a characteristic of MPDA. This disclosed in Macromolecules, Vol. 35, 8708 (2002). Therefore, the use of MPDA has the problem of difficulty in producing an intended linear high-molecular-weight polyimide precursor. Since the cyclic oligomer has a low molecular weight, little entanglement of polymer chains occurs, and thus the cyclic oligomer is expected to have higher thermoplasticity and solvent solubility than a corresponding linear polymer. However, the cyclic oligomer may have significantly decreased film toughness and possibly does not function as an adhesive.

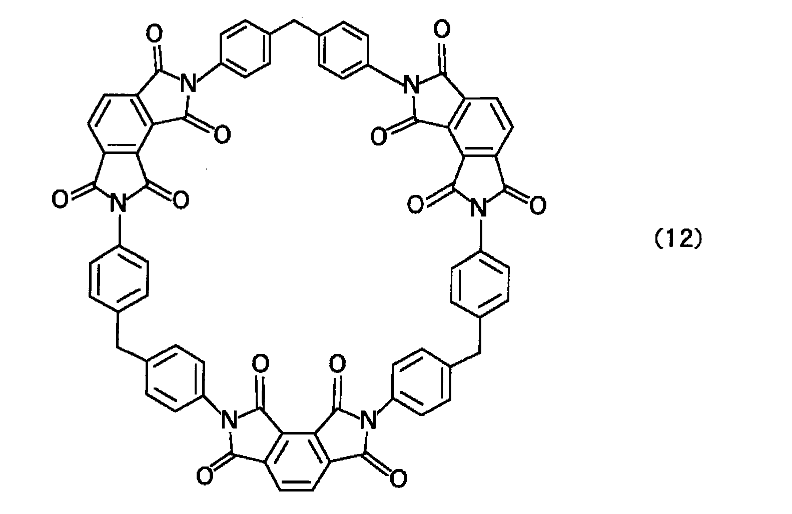

When a flexible diamine having a highly symmetric structure, such as 4,4'-methylenedianiline, 4,4'-oxydianiline, or 1,4-bis(4-aminophenoxy)benzene is used alone, the cyclic oligomer represented by Formula (12) tends to be easily produced. Therefore, in order to obtain a high-molecular-weight polyimide precursor and polyimide, it is effective to use an asymmetric diamine such as 3,4'-oxydianiline.

Even when a flexible diamine having a highly symmetric structure is used as described above, a linear high-molecular-weight polyimide precursor is produced once at an early stage of the polymerization reaction, thereby causing a rapid increase in viscosity of a polymerization reaction solution. However, then the polyimide precursor is converted to a more stable cyclic oligomer through an amide exchange reaction, thereby causing a rapid decrease in viscosity of the solution. The polyimide precursor of the present invention can be isolated as a high-molecular-weight linear polyimide precursor by adding dropwise the polymerization solution to a poor solvent with such timing that the viscosity of the polymerization reaction solution becomes the highest during viscosity tracing. A high-molecular-weight linear polyimide can be produced by charging a chemical imidization reagent in the polymerization solution or causing a cyclodehydration reaction (imidization reaction) through heat reflux of the polymerization solution with that timing. Once imidization has taken place, conversion into the cyclic oligomer never occurs.

When the monomer concentration is low in preparing the polyimide precursor, intramolecular end linking preferentially occurs as compared with elongation of the polymer chain, thereby easily producing the cyclic oligomer. Therefore, in order to obtain a high-molecular-weight polyimide precursor, it is effective to adjust the monomer concentration to be as high as possible.

It is also important to appropriately select a solvent used for preparing the polyimide precursor. To obtain the high-molecular-weight polyimide precursor, it is effective to use a solvent having as high affinity as possible for the linear polyimide precursor. In a high-affinity solvent, solvent molecules enter polymer chain coils to stretch the polymer chain, thereby causing conditions in which the cyclic oligomer is not easily produced by the reaction between terminals. When comparing general-purpose amide solvents, in a polymerization reaction system for the polyimide precursor using MPDA, the viscosity of the polymerization solution is slowly decreased using N-methyl-2-pyrrolidone (NMP) as compared with N,N-dimethylacetamide (DMAc). Therefore, N-methyl-2-pyrrolidone is a solvent suitable for producing the high-molecular-weight linear polyimide precursor.

### <Method for producing polyimide precursor>

A method for producing a polyimide precursor according to the present invention is described in detail. The polyimide precursor is prepared as follows: First, a diamine component is dissolved in a polymerization solvent, and powder of MPDA represented by formula (7) is added to the resultant solution. Then, powder of reactive dicarboxylic anhydride represented by formula (8) is added to the solution, followed by stirring with a mechanical stirrer at room temperature for 0.5 to 48 hours. In this case, the monomer concentration is 10 to 50% by mass, preferably 20 to 40% by mass. A more uniform polyimide precursor solution with a higher degree of polymerization can be prepared by polymerization in this monomer concentration range.

A polyimide precursor with a higher degree of polymerization tends to be produced at a higher monomer concentration. Therefore, to secure the toughness of the resulting polyimide, polymerization is preferably initiated at as high a monomer concentration as possible. Further, the polymerization reaction time when the viscosity of the solution reaches its maximum is preferably accurately determined by measuring the viscosity of the polymerization reaction solution through frequent sampling or by tracing viscosity changes using a stirrer with a torque meter. At that timing, imidization is preferably performed.

The polyimide precursor represented by the formula (1) or (2) is synthesized as follows: First, a diamine component (P moles) is dissolved in a polymerization solvent, and a predetermined amount of MPDA powder (P - 0.5 x Q moles) is added to the resultant solution. Then, thermal crosslinking reactive dicarboxylic anhydride (Q moles) is added to the solution, followed by stirring with a mechanical stirrer at room temperature for 0.5 to 48 hours. In this case, the content (%) (= 0.5Q/P x 100) of thermal crosslinking reactive dicarboxylic anhydride is in a range of 0.1 to 50%, preferably 0.2 to 10%.

Examples of the polymerization solvent include, but are not limited to, aprotic solvents such as N-methyl-2-pyrrolidone, N,N-dimethylacetamide, N,N-diethylacetamide, N,N-dimethylformamide, hexamethylphosphoramide, dimethyl sulfoxide, γ-butyrolactone, 1,3-dimethyl-2-imidazolidinone, 1,2-dimethoxyethane-bis(2-methoxyethyl) ether, tetrahydrofuran, 1,4-dioxane, picoline, pyridine, acetone, chloroform, toluene, and xylene; and protic solvents such as phenol, o-cresol, m-cresol, p-cresol, o-chlorophenol, m-chlorophenol, and p-chlorophenol. These solvents may be used alone or used as a mixture of two or more. Because the viscosity of the polymerization reaction solution is slowly decreased, N-methyl-2-pyrrolidone (NMP) is suitably used.

Examples of an aromatic diamine which can be used within a range where the demand characteristics of the polyimide are not significantly impaired include, but are not particularly limited to, 2,2'-bis(trifluoromethyl)benzidine, p-phenylenediamine, m-phenylenediamine, 2,4-diaminotoluene, 2,5-diaminotoluene, 2,4-diaminoxylene, 2,4-diaminodurene, 4,4'-diaminodiphenylmethane, 4,4'-methylene bis(2-methylaniline), 4,4'-methylene bis(2-ethylaniline), 4,4'-methylene bis(2,6-dimethylaniline), 4,4'-methylene bis(2,6-diethylaniline), 4,4'-diaminodiphenyl ether, 3,4'-diaminodiphenyl ether, 3,3'-diaminodiphenyl ether, 2,4'-diaminodiphenyl ether, 4,4'-diaminodiphenyl sulfone, 3,3'-diaminodiphenyl sulfone, 4,4'-diaminobenzophenone, 3,3'-diaminobenzophenone, 4,4'-diaminobenzanilide, benzidine, 3,3'-dihydroxybenzidine, 3,3'-dimethoxybenzidine, o-tolidine, m-tolidine, 1,4-bis(4-aminophenoxy)benzene, 1,3-bis(4-aminophenoxy)benzene, 1,3-bis(3-aminophenoxy)benzene, 4,4'-bis(4-aminophenoxy)biphenyl, bis(4-(3-aminophenoxy)phenyl)sulfone, bis(4-(4-aminophenoxy)phenyl)sulfone, 2,2-bis(4-(4-aminophenoxy)phenyl)propane, 2,2-bis(4-(4-aminophenoxy)phenyl)hexafluoropropane, 2,2-bis(4-aminophenyl)hexafluoropropane, p-terphenylenediamine, and the like. These aromatic diamines can be used in combination of two or more.

In terms of inhibiting the cyclic oligomer formation when the polyimide precursor is prepared and also securing thermoplasticity and solubility of the polyimide, it is preferably to used a flexible diamine such as 2,2-bis(4-(4-aminophenoxy)phenyl)propane, 2,2-bis(4-(4-aminophenoxy)phenyl)hexafluoropropane, 2,2-bis(4-aminophenyl)hexafluoropropane, 3,4'-diaminodiphenyl ether, 3,3'-diaminodiphenyl ether, 2,4'-diaminodiphenyl ether, 4,4'-diaminodiphenyl sulfone, 3,3'-diaminodiphenyl sulfone, or the like.

Examples of aliphatic amines which can be used within a range where the demand characteristics of the polyimide are not significantly impaired include, but are not limited to, trans-1,4-diaminocyclohexane, cis-1,4-diaminocyclohexane, 1,4-diaminocyclohexane (trans/cis mixture), 1,3-diaminocyclohexane, isophorone diamine, 1,4-cyclohexane bis(methylamine), 2,5-bis(aminomethyl)bicyclo[2.2.1]heptane, 2,6-bis(aminomethyl)bicyclo[2.2.1]heptane, 3,8-bis(aminomethyl)tricyclo[5.2.1.0]decane, 1,3-diaminoadamantane, 4,4'-methylene bis(cyclohexylamine), 4,4'-methylene bis(2-methylcyclohexylamine), 4,4'-methylene bis(2-ethylcyclohexylamine), 4,4'-methylene bis(2,6-dimethylcyclohexylamine), 4,4'-methylene bis(2,6-diethylcyclohexylamine), 2,2-bis(4-aminocyclohexyl)propane, 2,2-bis(4-aminocyclohexyl)hexafluoropropane, 1,3-propanediamine, 1,4-tetramethylenediamine, 1,5-pentamethylenediamine, 1,6-hexamethylenediamine, 1,7-heptamethylenediamine, 1,8-octamethylenediamine, 1,9-nonamethylenediamine, and the like. These aliphatic diamines can be used in combination of two or more.

A tetracarboxylic dianhydride component other than mellophanic dianhydride may be partially used as long as the demand characteristics and polymerization reactivity of the polyimide according to the present invention are not significantly impaired. Examples of an acid dianhydride which can be used for copolymerization include, but are not limited to, aromatic tetracarboxylic dianhydrides such as pyromellitic dianhydride, 3,3',4,4'-biphenyltetracarboxylic dianhydride, 3,3',4,4'-benzophenonetetracarboxylic dianhydride, 3,3',4,4'-biphenyl ether tetracarboxylic dianhydride, 3,3',4,4'-biphenyl sulfone tetracarboxylic dianhydride, 2,2'-bis(3,4-dicarboxyphenyl)hexafluoropropanoic dianhydride, 2,2'-bis(3,4-dicarboxyphenyl)propanoic dianhydride, 1,4,5,8-naphthalenetetracarboxylic dianhydride, 2,3,6,7-naphthalenetetracarboxylic dianhydride, and the like; and alicyclic tetracarboxylic dianhydrides such as bicyclo[2.2.2]oct-7-ene-2,3,5,6-tetracarboxylic dianhydride, 5-dioxotetrahydrofuryl-3-methyl-3-cyclohexene-1,2-dicarboxylic anhydride, 4-(2,5-dioxotetrahydrofuran-3-yl)-tetralin-1,2-dicarboxylic anhydride, tetrahydrofuran-2,3,4,5-tetracarboxylic dianhydride, bicyclo-3,3',4,4'-tetracarboxylic dianhydride, 3c-carboxymethylcyclopentane-1r,2c,4c-tricarboxylic acid 1,4:2,3-dianhydride, 1,2,4,5-cyclohexanetetracarboxylic dianhydride, 1,2,3,4-cyclobutanetetracarboxylic dianhydride, 1,2,3,4-cyclopentanetetracarboxylic dianhydride, and the like.

These dianhydrides may be used alone or in combination or two or more as a copolymerization component.

The polyimide precursor of the present invention can be used as a film by applying a solution (varnish) thereof to a substrate and then by drying it. In addition, the polyimide precursor can be isolated as powder by properly diluting the varnish, adding dropwise the varnish into a poor solvent such as a large amount of water or methanol to produce precipitates, and filtering out and drying the precipitates.

The intrinsic viscosity of the linear polyimide precursor of the present invention is desirably as high as possible in terms of toughness of a polyimide film. The intrinsic viscosity is preferably at least 0.1 dL/g or more, more preferably 0.3 dL/g or more, most preferably 0.5 dL/g or more. When the intrinsic viscosity is less than 0.1 dL/g, film formability is significantly degraded, thereby causing a serious problem that a cast film of the polyimide is cracked, or satisfactory adhesive strength cannot be achieved when the polyimide is used as a CCL adhesive layer. The intrinsic viscosity is desirably less than 5.0 dL/g in terms of handling of varnish of the polyimide precursor.

### <Method for producing polyimide>

An alicyclic structure-containing polyimide of the present invention can be produced by a cyclodehydration reaction (imidization reaction) of the polyimide precursor produced by the above-described method. In this case, applicable forms of the polyimide include a film, a metal substrate/polyimide film laminate, a powder, a molded product, and a solution.

First, a method for producing a polyimide film is described. A solution (varnish) of the polyimide precursor is cast on a substrate composed of an insoluble polyimide film, glass, copper, aluminum, stainless steel, silicon, or the like, and then dried in an oven at 40°C to 180°C, preferably 50°C to 150°C. The polyimide film of the present invention can be produced by heating the resulting polyimide precursor film on the substrate in vacuum, in an inert gas such as nitrogen, or in air at 200°C to 400°C, preferably 250°C to 300°C. The heating temperature is preferably 200°C or more in view of sufficient imidization cyclization reaction and preferably 300°C or less in view of thermal stability of the formed polyimide film. The imidization is desirably performed under vacuum or in an inert gas, but may be performed in air unless the imidization temperature is too high.

Instead of being thermally performed, the imidization reaction can be performed by immersing the polyimide precursor film into a solution containing a cyclodehydration reagent such as acetic anhydride in the presence of a tertiary amine such as pyridine or triethylamine. Furthermore, polyimide varnish can be prepared by previously adding a cyclodehydration reagent into a polyimide precursor varnish and then stirring the varnish at 20 to 100°C for 0.5 to 24 hours. The polyimide varnish is then added dropwise to a poor solvent such as water or methanol, followed by filtration to isolate polyimide powder. A polyimide film can also be formed by casting the polyimide varnish on the substrate described above and then drying it. The polyimide film may be further heat-treated in the temperature range described above.

When the polyimide itself is dissolved in the solvent used, the polyimide solution (varnish) of the present invention can be easily prepared by heating a varnish of the polyimide precursor, which is obtained through the polymerization reaction, to 150°C to 200°C with or without proper dilution with the same solvent. When the polyimide itself is insoluble in the solvent, polyimide powder can be obtained as a precipitate. In this case, toluene or xylene may be added to perform azeotropic distillation for removing water that is a by-product of the imidization reaction. A base such as γ-picoline can be added as a catalyst. After the imidization reaction, the reaction solution is added dropwise to a poor solvent such as water or methanol, followed by filtration to isolate polyimide powder. The polyimide powder can be dissolved again in the polymerization solvent to prepare polyimide varnish.

The polyimide of the present invention can be produced by one-stage polymerization, without isolation of the polyimide precursor, through a reaction between a tetracarboxylic dianhydride and a diamine in a solvent at a high temperature. In this case, the polymerization solution may be maintained at 130°C to 250°C, preferably 150°C to 200°C, in terms of reaction promotion. When the polyimide is insoluble in the solvent used, the polyimide is obtained as a precipitate, while when the polyimide is soluble in the solvent, the polyimide is obtained as varnish. Examples of the reaction solvent that can be used include, but are not limited to, aprotic solvents such as N,N-dimethylformamide, N,N-dimethylacetamide, N-methyl-2-pyrrolidone, dimethyl sulfoxide, and the like. More preferably, phenol solvents such as m-cresol or amide solvents such as NMP are used. Toluene or xylene can be added to the solvent to perform azeotropic distillation for removing water that is a by-product of the imidization reaction. A base such as γ-picoline can be added as an imidization catalyst. After the reaction, the solution is added dropwise to a poor solvent such as a large amount of water or methanol, followed by filtration to isolate a polyimide as powder. When the polyimide is soluble in the solvent, the powder can be dissolved again in the solvent to prepare polyimide varnish.

The polyimide film of the present invention can also be formed by applying the polyimide varnish to a substrate and then drying it at 40°C to 300°C. In addition, a molded product of the polyimide can be formed by heat-compressing the polyimide powder obtained as described above at 200°C to 450°C, preferably at 250°C to 430°C.

A polyisoimide that is an isomer of a polyimide is produced by adding a dehydrating reagent such as N,N-dicyclohexyl carbodiimide or trifluoroacetic anhydride to the polyimide precursor solution and then effecting a reaction by stirring at 0 to 100°C, preferably 0 to 60°C. The isoimidization reaction can be performed by immersing the polyimide precursor film into the solution containing the dehydrating agent. After a film is formed using the polyisoimide varnish in the same procedures as described above, the polyisoimide can be easily converted into a polyimide by heat treatment at 250°C to 350°C.

The polyimide varnish of the present invention is applied to a copper foil or a non-thermoplastic polyimide film, dried, and then heat-treated in a nitrogen atmosphere or vacuum in a range of 300°C to 450°C, preferably 350°C to 400°C, so that adhesive force and film toughness can be improved by thermal crosslinking of terminal crosslinking groups.

If required, additives such as an oxidation stabilizer, a filler, an adhesion promoter, a silane coupling agent, a photosensitizer, a photopolymerization initiator, a sensitizer, an end stopper, and a crosslinking agent can be added to the polyimide or the precursor thereof according to the present invention.

After the polyimide varnish prepared as described above is cast on a surface of an insoluble polyimide film to form a film, a copper clad laminate can be formed by placing a copper foil on the film and then heat-pressing the copper foil. In addition, after a photoresist is applied to the copper foil and patterned by exposure, a flexible printed circuit (FPC) can be formed by forming a circuit through etching the copper foil with an aqueous ferric chloride solution or the like.

As characteristics required for applying the polyimide of the present invention to an adhesive for pseudo two-layer CCL, the glass transition temperature of the polyimide is preferably 270°C or more, and the breaking elongation in a tensile test is preferably 10% or more, more preferably 20% or more. The polyimide is preferably dissolved in a general-purpose aprotic organic solvent such as NMP or DMAc by 10% by mass or more, more preferably 20% by mass or more. The polyimide of the present invention preferably has as high thermoplasticity as possible. When the laminate is formed with the copper foil, the peel strength is preferably 1.0 kgf/cm or more, more preferably 1.2 kgf/cm or more, as an index of thermoplasticity.

### <Applications>

The polyimide of the present invention has good workability, that is, solubility in an organic solvent and thermoplasticity together with a high glass transition temperature and high toughness. Therefore, the polyimide is significantly useful as a heat-resistant adhesive for pseudo two-layer CCL.

### EXAMPLES

The present invention is described in detail below with reference to examples, but the present invention is not limited to these Examples. The physical properties in the examples were measured by the following methods.

### <Intrinsic viscosity>

The intrinsic viscosity of a 0.5% by mass solution (solvent: DMAc or NMP) of a polyimide precursor or a polyimide was measured at 30°C using an Ostwald viscometer.

### <Glass transition temperature: Tg>

The glass transition temperature of a polyimide film was determined from a loss peak at a frequency of 0.1 Hz and at a heating rate of 5 °C/min through dynamic viscoelasticity measurement using a thermal mechanical analyzer (TMA4000) manufactured by Bruker AXS, Inc.

### <Coefficient of linear thermal expansion: CTE>

The coefficient of linear thermal expansion of a polyimide film was measured as an average value within a range of 100°C to 200°C based on the elongation of a specimen at a load of 0.5 g/l µm film thickness and a heating rate of 5 °C/min. The elongation was determined by thermal mechanical analysis using a thermal mechanical analyzer (TMA4000) manufactured by Bruker AXS, Inc.

### <5% mass loss temperature: Td⁵>

The temperature when the initial mass of a polyimide film was decreased by 5% in a temperature rising process at a heating rate of 10°C/min in a nitrogen atmosphere or in air was measured using a thermal mass analyzer (TG-DTA2000) manufactured by Broker AXS, Inc. A higher value of 5% mass loss temperature indicates higher thermal stability.

### <Water absorption>

After a polyimide film (film thickness: 20 to 30 µm) which was dried under vacuum at 50°C for 24 hours was immersed in water at 25°C for 24 hours, excess water was removed and water absorption (%) was determined from a mass increase.

### <Elastic modulus, breaking elongation, breaking strength>

A tensile test (drawing rate: 8 mm/min) was conducted for a polyimide film specimen (3 mm x 30 mm) using a tensile test machine (Tensilon UTM-2) manufactured by Toyo Baldwin Co., Ltd. An elastic modulus was determined from an initial gradient of a stress-strain curve. A breaking elongation (%) was determined from an elongation percentage when the film was broken. A higher breaking elongation indicates higher toughness of a film.

### <Solubility test>

Solubility at room temperature was measured by inserting 10 mg of polyimide powder into 1 mL of solvents.

### <Peel test: peel strength>

Pseudo two-layer CCL was formed as follows. Polyimide varnish (solvent: NMP, concentration: 15 to 20% by mass) of the present invention was applied to a matte surface of an electrolytic copper foil (F2-WS with a thickness of 12 µm manufactured by FURUKAWA ELECTRIC CO., LTD.), dried at 120°C for 2 hours, and then dried at 250°C under vacuum for 2 hours. Then, a non-thermoplastic polyimide film (Apical NPI with a thickness of 25 µm manufactured by KANEKA CORPORATION) was heat-compressed onto the surface of the thermoplastic polyimide film by pressing under a pressure of 6.2 MPa at 350°C for 30 minutes to form a specimen. A 180° peel test was conducted on the specimen under the same conditions as those of the tensile test described above to measure peel strength. As a result of the peel test, peeling occurred at an interface between the polyimide adhesive layer and the copper foil in all samples.

### (Synthesis Example)

### Synthesis of mellophanic dianhydride

### <Synthesis of 1,2,3,4-benzenetetracarboxylic acid>

1,2,3,4-benzenetetracarboxylic acid was synthesized by liquid-phase oxidation reaction of 1,2,3,4,5,6,7,8-octahydrophenanthrene using potassium permanganate or the like as an oxidizing agent (refer to the specification of Japanese Patent Application No. 2007-110118).

### <Synthesis of mellophanic dianhydride>

In accordance with a method described in Macromolecules, Vol. 35, 8708 (2002), mellophanic dianhydride was synthesized by reaction of 1,2,3,4-benzenetetracarboxylic acid and an excessive amount of acetic anhydride. The analysis values of the resulting mellophanic dianhydride were, for example, as follows.

Melting point: 196.5 to 198°C, GC purity: 99.8%, elemental analysis: carbon 54.8%, hydrogen 0.98%, oxygen 44.2%

### <Preparation of crosslinking end group-containing polyimide precursor, imidization, heat curing, and evaluation of characteristics of cured film>

### (EXAMPLE 1)

In a well-dried sealed reactor with a stirrer, 10 mmol of 2,2-bis(4-(4-aminophenoxy)phenyl)propane (hereinafter referred to as "BAPP") was placed and then dissolved in 25 mL of NMP that was sufficiently dehydrated with molecular sieves 4A. Then, 9.9 mmol of mellophanic dianhydride (hereinafter referred to as "MPDA") powder described above in Synthesis Example and 0.2 mmol of nadic anhydride (hereinafter referred to as "NA") were added to the resulting solution (total solute concentration: about 20% by mass). The resultant mixture was stirred at room temperature for 3 hours to prepare a crosslinking end group-containing polyimide precursor solution that was uniform and viscous. The resulting varnish did not cause precipitation or gelation even after being allowed to stand at room temperature or -20°C for 1 month, thereby exhibiting significantly high solution storage stability. The intrinsic viscosity of the polyimide precursor in NMP was measured at a concentration of 0.5% by mass and at 30°C with an Ostwald viscometer. As a result, the intrinsic viscosity was 0.43 dL/g. After the polyimide precursor varnish was properly diluted, a chemical imidization reagent (acetic anhydride/pyridine = 7/3 by volume, amount of acetic anhydride: moles of 5 times the theoretical dehydration amount) was added dropwise to the diluted varnish, followed by chemical imidization by stirring at room temperature for 12 hours.

The resulting polyimide varnish was added dropwise to a large amount of methanol to isolate a crosslinking end group-containing polyimide as powder, and the resulting polyimide powder was vacuum-dried at 80°C for 12 hours. As a result of a solubility test using the polyimide powder, high solubility was shown at room temperature for NMP, DMAc, N,N-dimethylformamide, γ-butyrolactone, dimethylsulfoxide, and chloroform. Then, the polyimide powder was dissolved (15 to 20% by mass) again in NMP to form varnish. The varnish was applied to a glass substrate and dried at 80°C for 2 hours with hot air to form a polyimide film. The resulting polyimide film on the substrate was further heat-treated under vacuum to obtain a polyimide film having a thickness of about 20 µm. In this case, the heat treatment conditions used included the following three types: [1] 250°C and 2 hours, [2] 350°C and 2 hours, and [3] 400°C and 1 hour. Table 1 shows the physical property data of the resulting film. In heat treatment at 250°C for 2 hours, thermal crosslinking of end groups little took place, and thus Tg of the polyimide film was 258°C. However, Tg became 270°C in heat treatment at 350°C for 2 hours, and Tg was increased to 282°C in heat treatment at 400°C for 1 hour. As a result of a tensile test for the heat-cured film produced by heat treatment at 350°C for 2 hours, the Young's modulus was 1.44 GPa, and the breaking strength was 0.077 GPa, thereby showing low elasticity. Thus, the film was found to be suitable for a heat-resistant adhesive for low-repellency CCL which has recently been increasingly required. In addition, the breaking elongation was 59.8% which showed high toughness. In addition, the 5% by mass loss temperature was 480°C in nitrogen and 449°C in air, and thus the film had sufficiently high thermal stability. A value of water absorption of as relatively low as 0.70% was exhibited. Further, a peel test of pseudo two-layer CCL which was formed using the polyimide as an adhesive showed a value of peel strength of as high as 1.47 kgf/cm.

### (EXAMPLE 2)

Chemical imidization and film formation were performed by the same method as in Example 1 except that the charging amounts of BAPP, MPDA, and NA monomers were changed to 10 mmol, 9.95 mmol. and 0.1 mmol, respectively, and the physical properties were evaluated. Table 1 shows physical property data.

### (COMPARATIVE EXAMPLE 1)

A polyimide precursor was polymerized and then imidized by charging a chemical imidization reagent by the same method as in Example 1 except that pyromellitic dianhydride (hereinafter referred to as "PMDA") was used as a tetracarboxylic dianhydride in place of mellophanic dianhydride. However, the reaction solution was gelled, and thus the physical properties were not evaluated. This is because the polyimide has low solubility due to use of PMDA.

### (COMPARATIVE EXAMPLE 2)

Chemical imidization and film formation were performed by the same method as in Example 1 except that a high-molecular-weight polyimide precursor was polymerized by reaction of equal moles of MPDA and BAPP without using NA serving as an end crosslinking agent, and the physical properties were evaluated. Table 1 shows physical property data. The resulting polyimide film shows the same Tg as and higher breaking elongation than the cured film produced in Example 1. However, the peel strength was 0.84 kgf/cm.

**Table 1**

| | Heat treatment temperature (°C) | Intrinsic viscosity (dL/g) | Tg (°C) | CTE (ppm/K) | T_{d}⁵ (N₂) (°C) | T_{d}⁵ (air) (°C) | Water absorption (%) | Breaking elongation (%) | Young's modulus (GPa) | Breaking strength (GPa) | Peel strength (kgf/cm) |
|---|---|---|---|---|---|---|---|---|---|---|---|
| Example 1 | 250 | 0.43 | 258 | 58.2 | 487 | 441 | - | - | - | - | - |
| | 350 | 0.43 | 270 | 61.2 | 480 | 449 | 0.70 | 59.8 | 1.44 | 0.077 | 1.47 |
| | 400 | 0.43 | 282 | 60.0 | 468 | 440 | - | - | - | - | - |
| Example 2 | 250 | 0.51 | 268 | 59.2 | 486 | 446 | - | - | - | - | - |
| | 350 | 0.51 | 272 | 60.7 | 486 | 446 | 0.55 | 97.6 | 1.43 | 0.083 | 1.40 |
| | 400 | 0.51 | 304 | - | 471 | 436 | - | - | - | - | - |
| Comparative Example 2 | - | 1.57 | 280 | 53.6 | 490 | 457 | 0.93 | 161 | 1.92 | 0.110 | 0.84 |

### Industrial Applicability

According to the present invention, it is possible to provide a linear polyimide precursor having good workability, i.e., organic solvent solubility and thermoplasticity, and also having high adhesive force to a copper film and a non-thermoplastic polyimide film, a high glass transition temperature, and high toughness, or provide a linear polyimide and a heat-cured product thereof, and a method for producing them. Also, it is possible to provide CCL for electronic circuit boards for FPC, COF, and TAB by using them as a heat-resistant adhesive. Therefore, the present invention can greatly contribute to the industrial field.

## Claims

1. A linear polyimide precursor **characterized by** being produced from mellophanic dianhydride, diamine (NH₂-A-NH₂), and a monofunctional acid anhydride and containing a repeating unit represented by the following general formula (1) or (2); 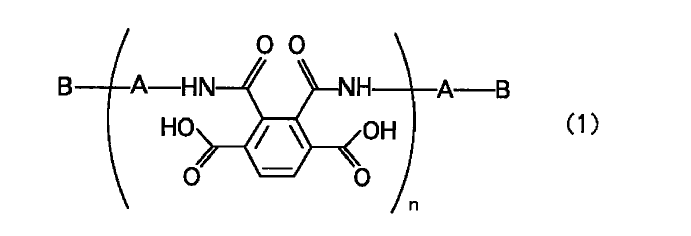 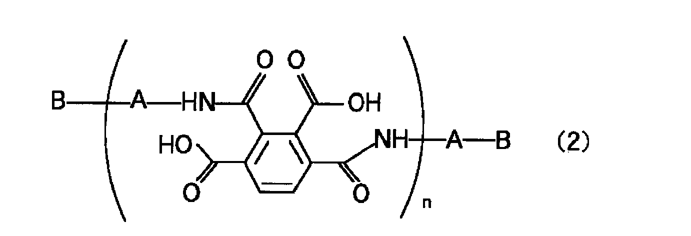 (wherein A represents a divalent aromatic diamine residue or aliphatic diamine residue, B represents a monofunctional acid anhydride residue, and n represents a degree of polymerization).

2. A linear polyimide **characterized by** containing a repeating unit represented by the following general formula (3); 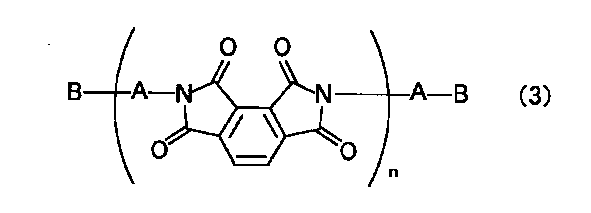 (wherein A represents a divalent aromatic diamine residue or aliphatic diamine residue, B represents a monofunctional acid anhydride residue, and n represents a degree of polymerization).

3. A heat-cured product **characterized by** being produced by a thermal crosslinking reaction of the polyimide according to Claim 2.

4. A method for producing the polyimide according to Claim 2, the method being **characterized by** cyclodehydration (imidization) reaction of the polyimide precursor according to Claim 1 by heating or a dehydration reagent.

5. The polyimide according to Claim 2 or the heat-cured product according to Claim 3, that has a glass transition temperature of 270°C or more, an aprotic organic solvent solubility of 10% by mass or more, a peel strength of 1.0 kgf/cm or more when formed in a laminate with a copper foil, and a breaking elongation of 10% or more in terms of film toughness.

6. A heat-resistant adhesive **characterized by** containing at least one selected from the group consisting of the polyimide according to Claim 2 and the heat-cured product according to Claim 3.

7. A copper clad laminate **characterized by** being produced by heat-laminating a non-thermoplastic polyimide film and a copper foil with the heat-resistant adhesive according to Claim 6.
